Europäisches Patentamt

(19) European Patent Office

Office européen des brevets

(11) Veröffentlichungsnummer: **0 209 816**
**B1**

(12) **EUROPÄISCHE PATENTSCHRIFT**

(45) Veröffentlichungstag der Patentschrift :
03.01.90

(51) Int. Cl.⁵ : **H 05 K   1/16, H 01 L 21/70,**
**H 01 F 41/04// G08B13/24**

(21) Anmeldenummer : 86109571.9

(22) Anmeldetag : 12.07.86

(54) Verfahren zur Herstellung ebener elektrischer Schaltungen.

(30) Priorität : 25.07.85 CH 3230/85

(43) Veröffentlichungstag der Anmeldung :
28.01.87 Patentblatt 87/05

(45) Bekanntmachung des Hinweises auf die Patenterteilung : 03.01.90 Patentblatt 90/01

(84) Benannte Vertragsstaaten :
AT BE CH DE FR GB IT LI LU NL SE

(56) Entgegenhaltungen :
WO–A–82/005 41
US–A– 4 467 311
US–A– 4 494 100
PATENTS ABSTRACTS OF JAPAN, Band 8, Nr. 91 (E-
241)[1528], 26. April 1984; & JP-A-59 11 610 (TDK K.K.)
21-01-1984
PATENTS ABSTRACTS OF JAPAN, Band 5, Nr. 70 (E-
56)[742], 12. Mai 1981; & JP-A-56 19 613 (MITSUBISHI
DENKI K.K.) 24-02-1981

(73) Patentinhaber : DURGO AG
Kapellplatz 2
CH-6000 Luzern (CH)

(72) Erfinder : Richter-Jörgensen, Poul
La Romantica 8 Urb. los Pinos
E-Almunecar (ES)

(74) Vertreter : Scheidegger, Werner & Co.
Stampfenbachstrasse 48 Postfach
CH-8023 Zürich (CH)

## Beschreibung

Die vorliegende Erfindung betrifft ein Verfahren zur Herstellung einer Vielzahl gleicher gedruckter Schaltungen auf einem gemeinsamen, ebenen, isolierenden Träger, dessen wenigstens eine Seite mit einer elektrisch leitfähigen Deckschicht versehen sind, insbesondere ein solches Verfahren zur Herstellung von Schwingkreisen, von denen jeder einen in sich abgeschlossenen Stromkreis mit spiralartig angeordneter, wenigstens eine Induktionsspule bildenden und wenigstens einen Kondensator enthaltenden Leiterbahnen aufweist. Siehe, z. B., WO-A-8 200 541.

Die vorliegende Erfindung betrifft somit insbesondere ein neuartiges Verfahren für die Herstellung von elektrischen Schwingkreisen, wie solche immer häufiger für besondere Anwendungen in den verschiedensten Industriezweigen eingesetzt werden. Derartige Schwingkreise dienen unter anderem zur Beobachtung und Erkennung von sich bewegenden Objekten, wobei die gegebenenfalls abgegebenen Signale zur Einleitung weiterer Verfahrensabläufe dienen (z. B. Steuerbefehle). Wird ein elektrischer Schwingkreis oder Resonanzstromkreis der genannten Art einer bestimmten Frequenz an einem Objekt befestigt, kann dieses in seinem Bewegungsablauf festgestellt und gesteuert werden.

So können beispielsweise Eisenbahnwagen, insbesondere Güterwagen über Weichen für verschiedene Bestimmungsorte umrangiert werden.

Entscheidend für solche Anwendungen ist, dass die Schwingkreise einerseits preisgünstig und andererseits, und dies vor allem, eine hohe Frequenzgenauigkeit und Spulenqualität aufweisen, damit Fehlsortierungen und Fehldetektionen mit hoher Wahrscheinlichkeit vermieden werden können.

Die im Zusammenhang mit der vorliegenden Erfindung zur Diskussion stehenden Schwingkreise sind im wesentlichen wie folgt aufgebaut: Auf einem flachen Träger aus einem elektrisch nichtleitenden Material (Dielektrikum) ist auf einer Seite eine aus umlaufenden Leiterbahnen gebildete Leiterspirale vorgesehen, welche die jeweiligen Induktionsspulen des Schwingkreises bilden, welche ihrerseits mit einem oder mehreren Kondensatoren bzw. mit einer oder mehreren leitenden Flächen, welche jeweils als Teil eines Kondensators dienen, elektrisch verbunden sind. Auf der andern Seite des Trägers sind entsprechend ausgebildete und deckungsgleich angeordnete, elektrisch untereinander verbundene leitende Flächen vorgesehen, welche als Gegenstücke des jeweiligen Kondensators dienen. Die Leiterbahnen der einen Seite sind mit jenen der anderen Seite unter Vervollständigung des Stromkreises an geeigneter Stelle miteinander verbunden.

Wie bereits erwähnt, dienen die Leiterbahnen der einen Seite als Induktionsspulen des Schwingkreises, während die grösseren leitenden Flächen mit den entsprechenden Flächen der anderen Seite und dem dazwischenliegenden Dielektrikum als Kondensatoren dienen. Der gesamte Stromkreis, bestehend aus den Induktionsspulen und einem der Kondensatoren, wird auf eine bestimmte Empfangsfrequenz abgestimmt. Die Schwingkreise sind oft so ausgebildet, dass ein gegebenenfalls weiter vorhandener Kondensator zusammen mit einer zugeordneten Induktionsspule auf eine sog. Zerstörfrequenz abgestimmt wird, so dass der Schwingkreis nach einer erfolgten Signalabgabe ausser Funktion gesetzt werden kann (durch Abgabe von Energie mit der Zerstörungsfrequenz, was z. B. zur Zerstörung einer Verbindungsstelle im Stromkreis führt).

Soviel zum allgemeinen Aufbau der hier zur Diskussion stehenden, an sich bekannten Schwingkreise.

Wie bereits erwähnt, ist ein weitgefächerter Einsatz solcher Schwingkreise nur dann möglich, wenn diese Schwingkreise bei höchster Präzision (Frequenzgenauigkeit und Spulenqualität) auch gleichzeitig preisgünstig herstellbar sind.

Gefragt ist somit ohne Zweifel eine weitgehend automatische Massenfertigung. Eine solche scheiterte bis heute an den hohen Präzisionsanforderungen.

An wirtschaftlichen Ueberlegungen scheiterten zum Erreichen des Zieles Herstellungsverfahren, bei denen die Schaltmuster im Siebdruckverfahren oder Photobearbeitungsverfahren auf die Träger bzw. das Substrat aufgebracht werden. Diese Verfahren sind entweder zu langsam und verlangen nach hochspezialisierten Fachkräften oder sie sind sehr kompliziert und benötigen zudem besondere chemische Hilfsmittel.

Ein in neuester Zeit angewandtes Verfahren macht sich die Aetztechnik zum Herausarbeiten von Leiterbahnen zunutze. Dieses Verfahrenb erlaubt zwar eine vergleichsweise wirtschaftliche Produktion, bei welcher eine Vielzahl von einzelnen Schwingkreisen praktisch gleichzeitig herstellbar sind, jedoch fehlt dabei die geforderte höchste Präzision bzw. eine wirtschaftliche Möglichkeit zur nachträglichen Korrektur eines nicht innerhalb einer vorgegebenen Toleranz liegenden Schwingkreises.

Zweck der vorliegenden Erfindung ist somit die Schaffung eines neuartigen Verfahrens zur wirtschaftlichen Herstellung von gedruckten Schaltungen, insbesondere von Schwingkreisen höchster Präzision.

Das Verfahren zeichnet sich zu diesem Zweck erfindungsgemäss dadurch aus, dass

a) auf einem blatt- oder bandförmigen, aus isolierendem Träger und wenigstens einseitig angebrachter leitender Deckschicht gebildeten Verbundkörper mittels Laserstrahlen eine Anzahl von Referenzlochungen angebracht werden, von denen jede je einer der zu erstellenden Schaltungen zugeordnet ist und deren gegenseitige Abstände von den Dimensionen der zu erstellenden Schaltungen abhängen und die Lochungen als Bezugspunkte für den Einsatz von Geräten für weitere Arbeitsschritte dienen ;

b) dass anschliessend die Grobkonturen der Schaltungen aus der bzw. den leitenden Deckschichten herausgearbeitet werden ;

c) dass danach mittels programm- bzw. rechnergesteuerten Laserstrahlen die die Schaltung bildenden Leiterbahnen aus der bzw. den leitenden Schichten herausgearbeitet werden, und

d) dass, gleichzeitig oder anschliessend, zur Fertigstellung der Schaltung die elektrischen Ist-Werte festgestellt und mit den Soll-Werten verglichen werden und bei unzulässiger Abweichung von den Soll-Werten die erforderlichen Korrekturen durch Nacharbeiten, z. B. mittels Laserstrahlen vorgenommen werden.

In einer besonders geeigneten Ausführungsform sollen Schwingkreise hergestellt werden, von denen jeder einen in sich abgeschlossenen Stromkreis mit spiralartig angeordneten, wenigstens eine Induktionsspule bildenden und wenigstens einen Kondensator enthaltenden Leiterbahnen aufweist, wobei erfindungsgemäss so vorgegangen wird, dass

a) auf einem blatt- oder bandförmigen, aus isolierendem Träger und wenigstens einseitig angebrachter leitender Deckschicht gebildeten Verbundkörper mittels Laserstrahlen eine Anzahl von Referenzlochungen angebracht werden, von denen jede je einem der zu erstellenden Schwingkreise zugeordnet ist und deren gegenseitige Abstände von den Dimensionen der zu erstellenden Schwingkreise abhängen, und die Lochungen als Bezugspunkte für den Einsatz von Bearbeitungsgeräten für weitere Arbeitsschritte dienen ;

b) dass anschliessend die Grobkonturen der Schwingkreise und der vorgesehenen Kondensatorflächen aus der bzw. den elektrisch leitfähigen Deckschichten herausgearbeitet werden ;

c) dass danach die zur Bildung der Kondensatoren dienenden Flächen auf die Enddimensionen gebracht bzw. bei einseitig vorgesehener leitfähiger Deckschicht auf der Rückseite separat angebracht werden und mittels programm- bzw. rechnergesteuerten Laserstrahlen die den Schwingkreis bildenden Leiterbahnen herausgearbeitet werden, und

d) dass, gleichzeitig oder anschliessend, zur Fertigstellung der Schwingkreise die elektrischen Ist-Werte festgestellt und mit den Soll-Werten verglichen werden und bei unzulässiger Abweichung von den Soll-Werten die entsprechenden Abstimmungen durch Nacharbeiten, z. B. mittels Laserstrahlen vorgenommen werden.

Die Referenzlochungen können entlang einer Geraden oder in Form eines koordinatennetzförmigen Rasters angebracht werden. Dazu, wie auch für das Herausarbeiten der Leiterbahnen können vorzugsweise mehrere, gleichzeitig arbeitende Laser eingesetzt werden.

Vorzugsweise erfolgt die Fertigungskontrolle der Schaltkreise durch deren Abtasten mittels Sonden, wobei die festgestellten Werte in einem Rechner mit den Sollwerten verglichen werden und letzterer erforderliche Korrekturbefehle an einen Korrektur- oder Abstimmungslaser weitergibt.

Gegebenenfalls erforderliche Korrekturarbeiten können von denselben Lasern ausgeführt werden, welche die Leiterbahnen herausarbeiten.

Die Erfindung wird nachstehend anhand eines in der Zeichnung dargestellten Ausführungsbeispiels noch etwas näher erläutert. Es zeigt :

Fig. 1 eine bandförmige Verbundfolie, mit entlang einer Geraden angebrachten Referenzlochungen ;

Fig. 2 eine etwas breitere bandförmige Verbundfolie, auf welcher ein zweireiher Raster von Referenzlochungen vorgesehen ist, und

Fig. 3a-3d verschiedene Stadien des Herstellungsverfahrens, rein schematisch und jeweils ausschnittsweise nur einen der Vielzahl von Schaltkreisen.

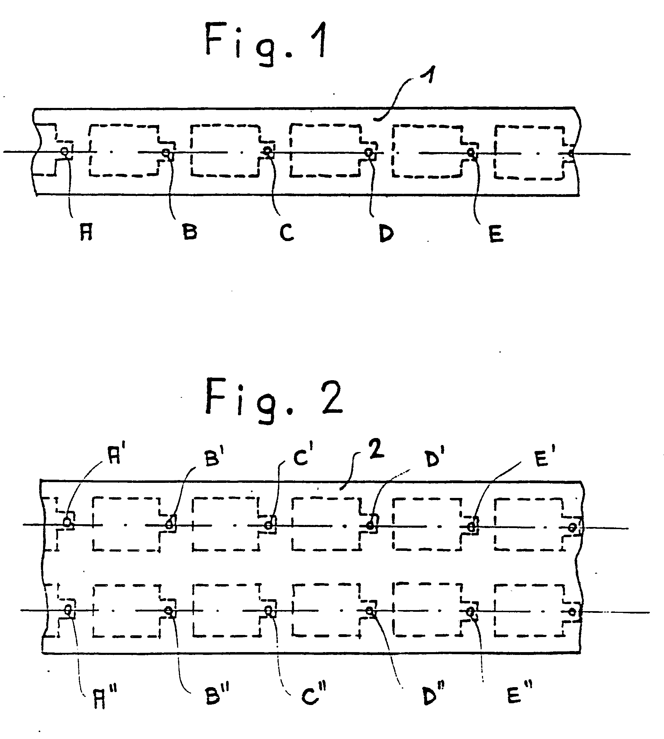

Fig. 1 der Zeichnung zeigt eine bandförmige Verbundfolie 1, welche erfindungsgemäss mit einer Anzahl Referenzlochungen A-E versehen wurde. Die Lochungen sind beim gezeigten Beispiel in der Folienstreifenmitte entlang einer Geraden mittels eines üblichen Industrielasers $L_1$ (nicht dargestellt) gebohrt worden. Wie bereits erwähnt, werden die Referenzlochungen mit Hilfe eines Industrielasers $L_1$ gebohrt, wobei der Abstand zwischen den Lochungen in Abhängigkeit der vorgesehenen Dimensionen der herzustellenden Schwingkreise variieren kann.

Die Referenzlochungen dienen als Bezugspunkte für den Einsatz aller nachher einzusetzenden Arbeitsgeräte, d. h. für den Einsatz der Arbeitsgeräte oder -maschinen für die nachfolgenden Produktionsschritte.

Die hohe Massgenauigkeit der Referenzpunkte, nicht nur zueinander, sondern auch des Loches selbst, ist eine Voraussetzung für die Endpräzision der elektrischen Weite der Schwingkreise. Laserbohrungen können mit einer extrem hohen Präzisionsgenauigkeit durchgeführt werden und erlauben dadurch eine Orientierung bezüglich der Verbundfolie und der weiteren Arbeitsgeräte von eben dieser Genauigkeit. Als Teil der Produktionsanlage ist ein Rechner vorgesehen. Dieser steuert den Laser $L_1$ in der x-Achse, falls mehrere Schwingkreise nicht nur hintereinander, sondern auch nebeneinander produziert werden sollen und dabei die Verbundfolie z. B. über eine Ab-/ Aufrolleinrichtung in der y-Achse entsprechend den vorgesehenen Dimensionen der gewünschten Schwingkreise verschoben wird.

Statt einem Laser können mehrere nebeneinander eingesetzt werden, wodurch sich die Arbeitszeiten entsprechend verkürzen, da mehrere Lochungen gleichzeitig gemacht werden können. Die Verschubzeit entlang der x-Achse von Loch zu Loch wird ebenfalls weitgehend reduziert. Es ergibt sich also ein Raster von Referenzlochungen auf der Verbundfolie. Diese Referenzlochungen können dann z. B. durch Photozellen mit Lichtschranken gekoppelt oder wieder über einen Laser oder eine Serie von Lasern angesteuert werden. Man hat also ein Koordinatensystem auf der Verbundfolie erstellt.

Fig. 2 der Zeichnung zeigt eine etwas breitere Verbundfolie 2, bei welcher zwei Reihen von Referenzlochungen A'-E'und A"-E" mittels einer oder mehreren Lasern angebracht wurden.

Als Grundmaterial für die Verbundfolie kommen handelsübliche Laminate zum Einsatz, welche nur eine Bedingung erfüllen müssen : Die leitende Deckschicht ist auf einem isolierenden Träger angeordnet, oder im Falle des Vorliegens von zwei Deckschichten sind diese durch eine isolierende Schicht voneinander getrennt. Hierbei sind vor allem Verbundfolien wie sie beispielsweise heute in der Verpackungsindustrie verwendet werden, am preisgünstigsten. Kombinationen von Aluminium/Polyäthylen(Aluminium) oder Aluminium/-Polyester (Aluminium) sind erhältlich, wobei die Isolationsschicht auch aus einer Polypropylen-, Azetat- oder einer sonstigen Kunststoffolie bestehen kann.

Die bei den genannten Produkten übliche Massgenauigkeit der Dicke der Metall- und Isolationsschichten ist dabei für den vorliegenden Zweck ausreichend. Das Rohmaterial kann ein Band beliebiger Länge sein oder auch in einzelnen Blättern verarbeitet werden, welche über ein Magazin dem Produktionsvorgang zugeführt werden. Die Breite des Bandes oder der Einzelblätter richtet sich nach der Anzahl der Schaltungen bzw. Schwingkreise, welche parallel nebeneinander produziert werden sollen.

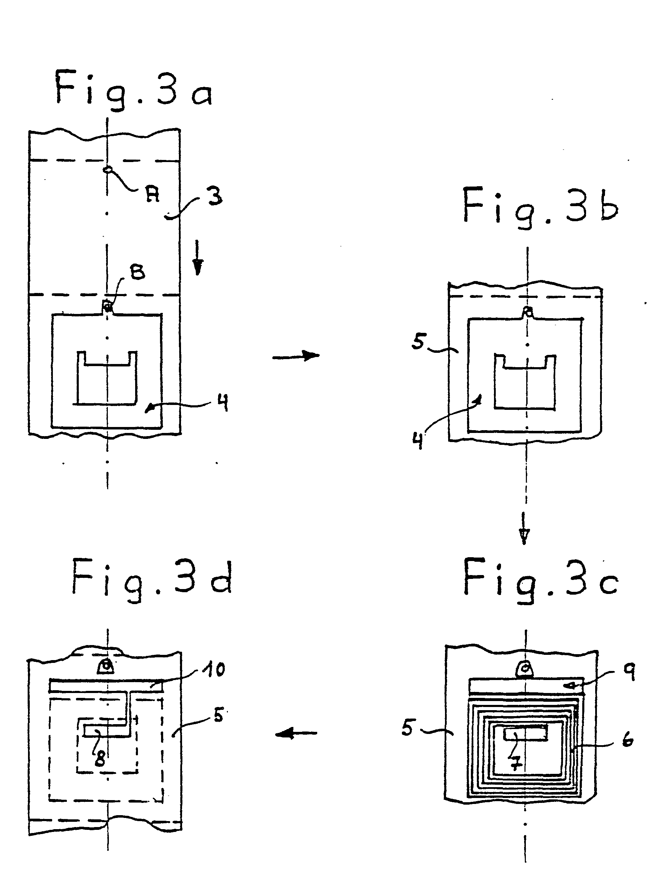

Fig. 3 der Zeichnung illustriert rein schematisch die weiteren Verfahrensschritte, nämlich :

Fig. 3a und 3b den zweiten wichtigen Schritt nach dem Anbringen der Referenzlochungen A, B etc., d. h. die Herausarbeitung der groben Aussenkontur 4 aus der leitenden Deckschicht 3 der Schaltungen, d. h. der Schwingkreise und der dazugehörigen Kondensatorenteile. Dies kann z. B. rein mechanisch, z. B. durch Stanzen, Fräsen oder sonstige geeignete Bearbeitungsverfahren erfolgen.

Eine besonders geeignete Methode basiert auf der bekannten Aetztechnik, wobei zuerst (Fig. 3a) die den groben Konturen der Schaltkreise entsprechenden Partien der leitenden Deckschichten, z. B. mittels einer Druckfarbe abgedeckt werden (mustergemässes Abdecken) und dann der Rest der leitenden Schichten von der isolierenden Kernschicht 5 entfernt wird (Fig. 3b).

Anschliessend an diese vorbereitenden Arbeiten erfolgt der wichtigste Verfahrensschritt, nämlich das Herausarbeiten aus den verbleibenden Teilen 4 der elektrisch leitenden Schicht 3 mittels Laserstrahlen eines Industrielasers $L_2$ (nicht dargestellt). Dabei wird die vorbereitete Leiterschicht 4 mittels rechnergesteuerten Laserstrahlen « geschlitzt ».

Dadurch entsteht im Falle der Herstellung von Schwingkreisen jeweils eine Aluminium- bzw. Metallspirale. Diese Spirale 6 kann oval, annähernd eckig oder kreisförmig sein, je nach vorgegebener Form des Schwingkreises. Der Laser $L_2$ wird in der x/y-Achse durch den Rechner entsprechend gesteuert. Die hohe Schnittgenauigkeit von Laserstrahlen, welche aus der Industrie hinreichend bekannt ist, ist eine weitere Grundlage zur Endgenauigkeit des gewünschten Schwingkreises. Arbeitsprozesse wie Stanzen oder Aetzen können in Massenproduktionsverfahren keine vergleichbare Genauigkeit erzielen. Die Detektion der Schwingkreise hängt weitgehend von der Spulenqualität und der Frequenzgenauigkeit ab. Die Spulenqualität ihrerseits hängt von der Leitfähigkeit des Materials ab ; hier wäre Silber als Material den Vorzug zu geben. Aluminium ist jedoch unter Berücksichtigung von Wirtschaftlichkeit vollkommen ausreichend. Im weiteren wird die Spulenqualität von der Schnittflächengleichmässigkeit der Leiterbahnen zueinander stark beeinflusst. Alle Unregelmässigkeiten der Schnittflächen zueinander verursachen kleinräumige elektrische Potentiale, welche auf den induzierten Stromfluss in der Spule als Ganzes reduzierend wirken und daher das Signal des Schwingkreises und die somit vorhandene Erkennungsmöglichkeit beeinträchtigen.

Laserschnitte weisen ein sehr hohes Mass an Schnittflächengleichmässigkeit auf. Diese Eigenschaft macht den Einsatz der Lasertechnologie für die Massenproduktion von Schwingkreisen so überaus vorteilhaft. Die hohe Schnittgenauigkeit dank der hohen Schusszahl pro Zeiteinheit, kombiniert mit handelsüblichen, d. h. preisgünstigen Verbundfolien, lassen die Produktion von hochpräzisen Schwingkreisen zu, welche billig genug sind, um z. B. als Massenmarkierungsmittel verwendet werden zu können. Durch den Einsatz mehrerer Laser $L_2$ nebeneinander, welche alle über den gleichen Rechner gesteuert werden, können mehrere Schwingkreise gleichzeitig produziert werden, wodurch sich die Wirtschaftlichkeit noch weiter verbessert.

Beim gezeigten Beispiel ist auf der Rückseite der Verbundfolie keine leitende Schicht vorgesehen. Es werden zu gegebenem Zeitpunkt, üblicherweise nach der Erstellung der Leiterbahnen, auf dieser Rückseite der Kondensatorflächen 7 entsprechende, deckungsgleiche Kondensatorflächen 8 und gegebenenfalls weitere Schaltungsteile angebracht. Solche Schaltungsteile können z. B. separat hergestellt sein und aufgeklebt oder aufgewalzt werden (Fig. 3d).

Es ist auch möglich, gleichzeitig bzw. anschliessend, auf der anderen Seite der Verbundfolie eine den vorderen Kondensatorflächen 7 entsprechende, deckungsgleiche Kondensatorfläche 8 aus einer dort vorhandenen leitenden Schicht herauszuarbeiten. Die auf den beiden Seiten der Verbundfolie liegenden Schaltungsteile werden zum Schliessen des Stromkreises in bekannter Weise elektrisch miteinander verbunden, z. B. indem die leitenden Flächen 9 und 10 über eine passende Bohrung durch den isolierenden Kern hindurch miteinander verbunden werden.

Der letzte Arbeitsschritt, welcher auch praktisch zusammen mit dem Herausarbeiten der Leiterbahnen ausgeführt werden kann, betrifft die Kontrolle bzw. die Toleranzkontrolle der vorgegebenen elektrischen Werte. Dazu kann z. B. eine Sonde den Schwingkreis abtasten und die elektrischen Werte über einen Rechner mit den vorgegebenen Werten vergleichen.

Ein weiterer Laser $L_3$ der über den Rechner gesteuert wird, korrigiert Schwingkreis und Kondensator, bis die Ist-Werte den Soll-Werten entsprechen. Je nach gewünschter Genauigkeit kann eine Toleranzbandbreite in den Rechenprozess einprogrammiert werden und dadurch die Arbeitszeit des Abstimmungslasers verkürzt werden.

Die oben angeführten Arbeitsschritte können auch mit mehreren Lasern, welche parallel gesteuert sind, ausgeführt werden. Dadurch ist es wieder möglich, mehrere Schaltkreise gleichzeitig abzugleichen. Im weiteren können die Arbeitsvorgänge der Laser $L_2$ und $L_3$ zusammengefasst werden. In diesem Fall wird Laser $L_2$ über den Rechner gesteuert, erstellt die Leiterbahnen und korrigiert Schwingkreis und Kondensator, bis der gewünschte Soll-Wert erreicht ist.

Dank dem geschilderten Verfahren ist es möglich geworden, hochpräzise Schaltungen, insbesondere hochpräzise Schwingkreise in praktisch vollautomatischer Produktion ausserordentlich wirtschaftlich, d. h. preisgünstig herzustellen.

Am Schluss können die fertiggestellten, geprüften und funktionstüchtigen Schwingkreise in die zum eigentlichen Einsatz gewünschte Verpackung eingebracht werden. Sowohl von Rollen wie von Blättern können die einzelnen Schwingkreise voneinander getrennt werden, oder als Band oder Blätter abgepackt werden. Die am Beginn des Herstellungsprozesses gebohrten Referenzlochungen können beibehalten werden und z. B. als Bedruckungsreferenzpunkte Verwendung finden. Die Schwingkreise auf Bändern können einseitig mit Klebstoff beschichtet und auf der anderen Seite mit Papier abgedeckt werden. Die Schwingkreise können auch in Plastikschalen eingeschweisst werden und mit einem Verschlussmechanismus an beliebige Objekte angebracht werden.

## Patentansprüche

1. Verfahren zur Herstellung einer Vielzahl gleicher gedruckter Schaltungen auf einem gemeinsamen, ebenen, isolierenden Träger, dessen wenigstens eine Seite mit einer elektrisch leitfähigen Deckschicht versehen ist, dadurch gekennzeichnet, dass

a) auf einem blatt- oder bandförmigen, aus isolierendem Träger und wenigstens einseitig angebrachter leitender Deckschicht gebildeten Verbundkörper mittels Laserstrahlen eine Anzahl von Referenzlochungen angebracht werden, von denen jede je einer der zu erstellenden Schaltungen zugeordnet ist und deren gegenseitige Abstände von den Dimensionen der zu erstellenden Schaltungen abhängen und die Lochungen als Bezugspunkte für den Einsatz von Geräten für weitere Arbeitsschritte dienen ;

b) dass anschliessend die Grobkonturen der Schaltungen aus der bzw. den leitenden Deckschichten herausgearbeitet werden ;

c) dass danach mittels programm- bzw. rechnergesteuerten Laserstrahlen die die Schaltung bildenden Leiterbahnen aus der bzw. den leitenden Schichten herausgearbeitet werden, und

d) dass, gleichzeitig oder anschliessend, zur Fertigstellung der Schaltung die elektrischen Ist-Werte festgestellt und mit den Soll-Werten verglichen werden und bei unzulässiger Abweichung von den Soll-Werten die erforderlichen Korrekturen durch Nacharbeiten vorgenommen werden.

2. Verfahren nach Anspruch 1, dadurch gekennzeichnet, dass bei einem einseitig mit einer leitfähigen Deckschicht versehenen Verbundkörper die zur Vervollständigung der Schaltung erforderlichen leitfähigen Teile auf der Rückseite in einem separaten Arbeitsgang aufgebracht werden.

3. Verfahren nach Anspruch 1 oder 2, zur Herstellung von Schwingkreisen, von denen jeder einen in sich abgeschlossenen Stromkreis mit spiralartig angeordneten, wenigstens eine Induktionsspule bildenden und wenigstens einen Kondensator enthaltenden Leitender nen aufweist, dadurch gekennzeichnet, dass

a) auf einem blatt- oder bandförmigen, aus isolierenden Träger und wenigstens einseitig angebrachter leitender Deckschicht gebildeten Verbundkörper mittels Laserstrahlen eine Anzahl von Referenzlochungen angebracht werden, von denen jede je einem der zu erstellenden Schwingkreise zugeordnet ist und deren gegenseitige Abstände von den Dimensionen der zu erstellenden Schwingkreise abhängen, und die Lochungen als Bezugspunkte für den Einsatz von Bearbeitungsgeräten für weitere Arbeitsschritte dienen ;

b) dass anschliessend die Grobkonturen der Schwingkreise und der vorgesehenen Kondensatorflächen aus der bzw. den elektrisch leitfähigen Deckschichten herausgearbeitet werden ;

c) dass danach die zur Bildung der Kondensatoren dienenden Flächen auf die Enddimensionen gebracht bzw. bei einseitig vorgesehener leitfähiger Deckschicht auf der Rückseite separat angebracht werden und mittels programm- bzw. rechnergesteuerten Laserstrahlen die den Schwingkreis bildenden Leiterbahnen herausgearbeitet werden, und

d) dass, gleichzeitig oder anschliessend, zur Fertigstellung der Schwingkreise die elektrischen Ist-Werte festgestellt und mit den Soll-Werten verglichen werden und bei unzulässiger Abweichung von den Soll-Werten die entsprechenden Abstimmungen durch Nacharbeiten, z. B. mittels Laserstrahlen vorgenommen werden.

4. Verfahren nach einem der Ansprüche 1 bis 3, dadurch gekennzeichnet, dass die Referenzlochuncen entlang einer Geraden angebracht werden.

5. Verfahren nach einem der Ansprüche 1 bis 3, dadurch gekennzeichnet, dass die Referenzlochungen in einem zweidimensionalen Raster in der Art eines Koordinatennetzes angebracht werden.

6. Verfahren nach einem oder mehreren der Ansprüche 1-5, dadurch gekennzeichnet, dass zur Bildung der Referenzlochungen und/oder der Leiterbahnen eine Mehrzahl von gleichzeitig arbeitenden Lasern eingesetzt werden.

7. Verfahren nach Anspruch 1 oder 3, dadurch gekennzeichnet, dass als Verbundkörper ein Verbundfolienmaterial mit einem isolierenden Kern und zwei leitenden Deckschichten eingesetzt wird.

8. Verfahren nach Anspruch 1 oder 3, dadurch gekennzeichnet, dass als Verbundkörper ein solcher mit einem Kern aus isolierendem Kunststoff, insbesondere Polyäthylen-, Polyester-, Azetat- oder Polypropylenfolie, und mit Deckschichten aus Metallfolien, insbesondere aus Aluminium, verwendet wird.

9. Verfahren nach einem oder mehreren der Ansprüche 1-8, dadurch gekennzeichnet, dass die Toleranzkontrolle der Schalt- bzw. Schwingkreise durch deren Abtasten mittels Sonden erfolgt, wobei die festgestellten Werte in einem Rechner mit den Sollwerten verglichen werden und letzterer erforderliche Korrekturbefehle an einen Korrektur- oder Abstimmungslaser weitergibt.

10. Verfahren nach einem oder mehreren der Ansprüche 1-9, dadurch gekennzeichnet, dass Abstimmungsbzw. Korrekturarbeiten von denselben Lasern ausgeführt werden, welche die Leiterbahnen herausarbeiten.

11. Verfahren nach einem oder mehreren der Ansprüche 1-10, dadurch gekennzeichnet, dass die Grobkonturen der Schaltungen durch mechanische Bearbeitung der entsprechenden Deckschicht, z. B. durch Stanzen oder Fräsen, oder durch eine chemische Bearbeitung, z. B. Aetzen herausgearbeitet werden.

12. Verfahren nach einem oder mehreren der Ansprüche 1-11, dadurch gekennzeichnet, dass nach Fertigstellung der auf einem gemeinsamen Träger vorliegenden Schaltungen, gegebenenfalls nach vorheriger Auftrennung in einzelne Schaltungselemente, diese mit Schutzschichten versehen und abgepackt werden.

## Claims

1. A method of producing a plurality of equal printed circuits on a common, planar insulating carrier of which at least one side is provided with an electrically conducting layer, comprising the steps of :

a) applying by means of laser rays a plurality of reference perforations on a sheet- or web-shaped composite body formed of an insulating carrier and at least on one side thereof an applied conductive covering layer, each individual one of said perforations being allocated to one respective circuit to be produced and the mutual distances of which depending from the dimensions of the circuits to be produced, which perforations serve as reference points for the application of devices for the performance of further working steps :

b) thereafter extricating the rough contours of the circuits of the conducting layer or layers respectively ;

c) thereafter extricating the conductive tracts forming the circuit of the conducting layer or layers respectively by means of program and computer controlled laser rays ; and

d) simultaneously or thereafter, in order to finish the circuit, determining the actual electrical values and comparing such with the design values, and carrying out necessary corrections by additional working in the case of undue deviation from the said design values.

2. The method according to claim 1, characterized in that on a composite body provided on one side only with an electrically conducting covering layer the conductive parts necessary for completing the circuit are applied to the back side by a separate working step.

3. The method according to claim 1 or 2, for producing oscillating circuits of which each comprises an electrical circuit closed in itself and including spirally arranged conduit tracts forming at least one induction coil and including at least one capacitor, comprising the steps of :

a) applying by means of laser rays a plurality of reference perforations on a sheet- or web-shaped composite body formed of an insulating carrier and at least on one side thereof an applied conducting layer, each individual one of said perforations being allocated to one respective oscillating circuit to be produced and the mutual distances of which depending from the dimensions of the oscillating circuits to be produced, which perforations serve as reference points for the application of processing devices for the performance of further working steps ;

b) thereafter extricating the rough contours of the oscillating circuits and of the intended capacitor surfaces at the electrically conductive covering layer or layers ;

c) therafter bringing the surfaces serving for the forming of the capacitors to the final dimensions or, with a conducting covering layer provided on one side only, applying them separately on the back side, and extricating, by means of program and computer controlled laser rays, the circuit tracts forming the oscillating circuit ; and

d) to finish the producing of the oscillating circuit, determining, simultaneously or thereafter, the actual electrical values and comparing such with the design values, to carry out corresponding adjustments by an additional working, e. g. by means of laser rays, in the case of undue deviation from the said design values.

4. The method according to any of claims 1 to 3, characterized in that said reference perforations are applied along a straight line.

5. The method according to any of claims 1 to 3, characterized in that said reference perforations are applied in a two dimensional pattern in the form of a system of coordinates.

6. The method according to one or a plurality of claims 1-5, characterized by using a plurality of simultaneously working lasers for forming said reference perforations and/or said circuit tracts.

7. The method according to claim 1 or 3, characterized by using as composite body a composite sheet material having an insulating core and two conducting covering layers.

8. The method according to claims 1 or 3, characterized by using as composite body a body with a core of insulating plastic material, particularly of sheet material of polyethylene, polyester, acetate or polypropylene, and with covering layers made of metal sheets, particularly of aluminium.

9. The method according to one or a plurality of claims 1-8, characterized in that the tolerance check of the switching- or oscillating-circuits respectively is carried out by their scanning by means of probes, whereby the determined values are compared with the design values by a computer which transmits necessary correction orders to a correction or adjustment laser.

10. The method according to one or a plurality of claims 1-9, characterized in that adjustment and correction works are carried out by the same lasers which are used for extricating the circuit tracts.

11. The method according to one or a plurality of claims 1-10, characterized in that the rough contours of the circuits are extricated by a mechanical treatment of the corresponding covering layer, e. g. by punching or cutting, or by a chemical treatment, e. g. by etching.

12. The method according to one or a plurality of claims 1-11, characterized in that after finishing of the circuits present on a common carrier, eventually after their separating into individual circuits, they are provided with a protective layer and finally packed.

**Revendications**

1. Procédé de fabrication d'un nombre de circuits imprimés égaux sur un support isolant commun plan dont au moins une face est pourvue d'une couche électriquement conductrice, caractérisé par les pas suivants :

a) on apporte au moyens de rayons laser un nombre de perforations de référence sur un corps composite sous forme de feuille ou ruban comprenant un support isolant et sur au moins l'une de ses faces une couche de surface conductrice, chaque perforation individuelle étant attribuée à un des circuits à fabriquer et leurs écartements mutuels dépendant des dimensions des circuits à fabriquer, lesdites perforations servant comme points de référence pour la mise en action de dispositifs pour d'autres opérations de travail ;

b) on excave ensuite les contours grossiers des circuits de la resp. des couches de surface conductrices ;

c) on excave ensuite les pistes conductives formant le circuit de la resp. des couches conductrices au moyen de rayons laser commandés par programme, resp. ordinateur, et

d) simultanément ou ensuite, pour ainsi finir le circuit, on détermine les valeurs électriques réelles et on les compare avec les valeurs prévues, et on procède à des travaux de correction nécessaires au cas de déviation inacceptable des valeurs prévues.

2. Procédé selon la revendication 1, caractérisé en ce que dans le cas d'un corps composite muni sur une face seulement d'une couche de surface conductrice, on applique les parties conductrices nécessaires pour compléter le circuit lors d'une opération séparée sur la face arrière du corps.

3. Procédé selon la revendication 1 ou 2, pour la fabrication de circuits oscillants dont chacun comprend un circuit électrique fermé sur lui-même présentant des pistes conductives en spirale formant au moins une bobine de self et contenant au moins un condensateur, caractérisé par les pas suivants :

a) on apporte au moyen de rayons laser un nombre de perforations de référence sur un corps composite sous forme de feuille ou ruban comprenant un support isolant et sur au moins l'une de ses faces une couche de surface conductrice, chaque perforation individuelle étant attribuée à un des circuits à fabriquer et leurs écartements mutuels dépendant des dimensions des circuits à fabriquer, lesdites perforations servant comme points de référence pour la mise en action de dispositifs pour d'autres opérations de travail ;

b) on excave ensuite les contours grossiers des circuits oscillants et des surfaces de condensateur prévues de la resp. des couches de surface conductrices ;

c) on ramène ensuite les surfaces servant à la formation des condensateurs à leurs dimensions finales ou, dans le cas d'une couche de surface conductrice prévue sur l'une des faces seulement, on les applique séparément sur la face arrière, et on excave au moyen de rayons laser commandés par programme, resp. ordinateur les pistes conductives formant le circuit oscillant, et

d) pour finir le circuit oscillant, on détermine simultanément ou ensuite les valeurs électriques réelles et on les compare avec les valeurs prévues, et, en cas de déviation inadmissible des valeurs prévues, on procède à leur accord conséquent par des opérations supplémentaires, par exemple au moyens de rayons laser.

4. Procédé selon l'une des revendications 1 à 3, caractérisé en ce que l'on apporte les perforations de référence le long d'une ligne droite.

5. Procédé selon l'une des revendications 1 à 3, caractérisé en ce que l'on apporte les perforations de référence selon un réseau à deux dimensions du type système de coordonnées.

6. Procédé selon l'une ou plusieurs des revendications 1 à 5, caractérisé en ce que l'on utilise plusieurs lasers travaillant simultanément pour la formation desdites perforations de référence et/ou des pistes conductives.

7. Procédé selon la revendication 1 ou 3, caractérisé en ce que l'on utilise comme corps composite un matériel composite en feuille présentant un noyau isolant et deux couches de surface conductrices.

8. Procédé selon la revendication 1 ou 3, caractérisé en ce que l'on utilise comme corps composite un corps en matière plastique isolante, particulièrement en feuille de polyéthylène, polyester, acétate ou polypropylène, et avec des couches de surface en feuilles de métal, particulièrement d'aluminium.

9. Procédé selon l'une ou plusieurs des revendications 1 à 8, caractérisé en ce que le contrôle des tolérances des circuits de commande, resp. circuits oscillants se fait au moyen d'un palpeur, les valeurs ainsi déterminées étant comparées avec les valeurs prévues dans un ordinateur qui transmettra des ordres de correction nécessaires à un laser de correction ou d'accord.

10. Procédé selon l'une ou plusieurs des revendications 1 à 9, caractérisé en ce que les travaux d'accord ou de correction sont effectués par les mêmes lasers qui sont utilisés pour excaver les pistes conductives.

11. Procédé selon l'une ou plusieurs des revendications 1 à 10, caractérisé en ce que les contours grossiers des circuits sont excavés par usinage mécanique de la couche de surface correspondante, par exemple par estampage ou fraisage, ou par un traitement chimique, par exemple par gravure.

12. Procédé selon l'une ou plusieurs des revendications 1 à 11, caractérisé en ce qu'après finition des circuits se trouvant sur un support commun le cas échéant après leur séparation préalable en circuits individuels, on les recouvre de couches protectrices et on les emballe.

# Fig. 1

A    B    C    D    E

# Fig. 2

A'    B'    C'    D'    E'

A"    B"    C"    D"    E"

1

# Fig.3a

# Fig.3b

# Fig.3d

# Fig.3c